(19) Europäisches Patentamt

European Patent Office

Office européen des brevets

(11) EP 0 533 245 B1

## (12) EUROPÄISCHE PATENTSCHRIFT

(45) Veröffentlichungstag und Bekanntmachung des Hinweises auf die Patenterteilung:
**10.12.1997 Patentblatt 1997/50**

(51) Int Cl.6: **H03M 1/78**, G06J 1/00

(21) Anmeldenummer: **92202736.2**

(22) Anmeldetag: **09.09.1992**

(54) **Multiplizierender Digital-Analog-Umsetzer**

Multiplying digital-analog converter

Convertisseur numérique-analogique multiplicateur

(84) Benannte Vertragsstaaten:
**DE FR GB IT NL**

(30) Priorität: **14.09.1991 DE 4130675**

(43) Veröffentlichungstag der Anmeldung:
**24.03.1993 Patentblatt 1993/12**

(73) Patentinhaber:
- **Philips Patentverwaltung GmbH
  22335 Hamburg (DE)**
  Benannte Vertragsstaaten:
  **DE**
- **Philips Electronics N.V.
  5621 BA Eindhoven (NL)**
  Benannte Vertragsstaaten:
  **FR GB IT NL**

(72) Erfinder:
- **Wölber, Jörg
  W-2000 Hamburg 1 (DE)**
- **Kröner, Klaus
  W-2000 Hamburg 1 (DE)**

(74) Vertreter: **von Laue, Hanns-Ulrich, Dipl.-Ing. et al
Philips Patentverwaltung GmbH,
Röntgenstrasse 24
22335 Hamburg (DE)**

(56) Entgegenhaltungen:
WO-A-81/00033     US-A- 3 857 021
US-A- 4 064 506     US-A- 4 168 528

- WESCON PROCEEDINGS SAN FRANCISCO, CA NOV. 19-22, 1885 Bd. 29 , November 1985 , NEW YORK Seiten 1 - 5 BARNES ET AL 'MULTI-QUADRANT VIDEO BAND MULTIPLIER USING BIPOLAR DAC'
- PROCEEDINGS OF THE 1989 BIPOLAR CIRCUITS AND TECHNOLOGY MEETING PAPER 2.4 18. September 1989 , MINNEAPOLIS MARRIOT CITY CENTER HOTEL Seiten 52 - 55 MARTINEZ ET AL 'A MONOLITHIC 12-BIT MULTIPLYING DAC FOR NTSC AND HDTV APPLICATIONS'

**Beschreibung**

Die Erfindung betrifft einen multiplizierenden Digital-Analog-Umsetzer mit einem R-2R-Kettennetzwerk, dessen Längswiderstände und dessen an den beiden Kettennetzwerkenden liegenden Querwiderstände jeweils einen Widerstandswert R und dessen übrige Querwiderstände einen doppelten Widerstandswert 2R aufweisen, wobei die den Längswiderständen abgewandten Enden der Querwiderstände mit einer Versorgungsspannung beaufschlagt sind und die den Längswiderständen zugewandten Enden der Querwiderstände Verbindungspunkte bilden.

Als multiplizierende Digital-Analog-Umsetzer werden solche Umsetzer bezeichnet, bei denen das analoge Ausgangssignal bezüglich seiner Amplitude abhängig ist von der Größe eines Stromes, der dem Umsetzer zugeführt wird. Dieser Strom wird bei einem Umsetzer mit einem R-2R-Kettennetzwerk auf verschiedene Verbindungspunkte des Kettennetzwerks geschaltet, wodurch in Abhängigkeit eines dem Umsetzer zugeführten und in den analogen Bereich umzusetzenden Digitalsignals am Ausgang entsprechende Spannungen bzw. Ströme auftreten. Wird nun dieser dem Digital-Analog-Umsetzer von außen zugeführte Strom zusätzlich in seiner Größe variiert, so wirkt sich dieses auch auf die Amplitude des Ausgangssignals des Umsetzers aus.

Derartige multiplizierende Digital-Analog-Umsetzer können also zur Amplitudeneinstellung eines Wechselstromsignals, das dem dem Umsetzer zugeführten Strom überlagert ist, eingesetzt werden. In Abhängigkeit des Digitalwortes wird dann auch die Amplitude dieses Wechselstromsignals entsprechend der Zustände der Bits des Digitalwortes verändert. Darüber hinaus wird jedoch auch der Strom, dem der Wechselstrom überlagert ist, in Abhängigkeit der Zustände der Bits verändert. Es tritt also am Ausgang des Umsetzers nicht nur der in seiner Amplitude variierte Wechselstrom auf, sondern auch ein solcher Spannungs- bzw. Stromwert, der der Umsetzung des konstanten Stroms entsprechend der Zustände der Bits des Digitalwortes dem analogen Bereich entspricht. Dem Wechselstrom bzw. Spannungssignal am Ausgang des Umsetzers ist also gleichsam eine Art Gleichstrom bzw. Spannung überlagert. Dieses Signal wird im folgenden als Offsetsignal bezeichnet.

In vielen Anwendungsfällen sind die zeitlichen Änderungen derartiger Offsetsignale unerwünscht, da beispielsweise für die Einstellung eines Lautstärkesignals mittels eines solchen multiplizierenden Digital-Analog-Umsetzers solche Spannungs- bzw. Stromsprünge unerwünscht sind, da sie hörbar werden.

Es ist Aufgabe der Erfindung, den eingangs genannten multiplizierenden Digital-Analog-Umsetzer dahingehend weiterzuentwickeln, daß die Einstellung eines Wechselstrom- bzw. Spannungssignals möglich wird, wobei gegebenenfalls ein völliger oder auch teilweiser Potentialausgleich erfolgt.

Diese Aufgabe wird erfindungsgemäß dadurch gelöst, daß

- das Kettennetzwerk für ein n-Bit breites, dem Umsetzer zugeführtes Digitalsignal (n + m) Verbindungspunkte aufweist, wobei n, m ganze natürliche Zahlen größer Null sind,
- der Verbindungspunkt (n + m) das Ausgangssignal des Umsetzers liefert,
- eine erste Stromspiegelanordnung vorgesehen ist, die einen konstanten ersten Strom liefert, der den Verbindungspunkten (1 + m) bis (n + m) einzeln aufschaltbar ist, wobei das niedrigswertige Bit des Digitalsignals dem Verbindungspunkt (1 + m) und das höchstwertige Bit dem Verbindungspunkt (n + m) zugeordnet ist und wobei der erste Strom nur auf diejenigen Verbindungspunkte geschaltet wird, deren zugeordnetes Bit einen ersten Zustand hat, und
- eine zweite Stromspiegelanordnung vorgesehen ist, die einen konstanten zweiten Strom liefert, welcher größer ist als derjenige der ersten Stromspiegelanordnung und der den Verbindungspunkten 1 bis n einzeln aufschaltbar ist, wobei das niedrigstwertige Bit dem Verbindungspunkt 1 und das höchstwertige Bit dem Verbindungspunkt n zugeordnet ist und wobei der zweite Strom nur auf diejenigen Verbindungspunkte geschaltet wird, deren zugeordnetes Bit einen zweiten Zustand hat.

Diese Maßnahmen gestatten es, mittels des Umsetzers ein ihm zugeführtes Wechselstromsignal bezüglich seiner Amplitude in Abhängigkeit des dem Umsetzer ebenfalls zugeführten Digitalsignals bezüglich seiner Amplitude einzustellen. Dabei ist ein völliger Potentialausgleich möglich, d.h. das in seiner Amplitude eingestellte Wechselstromsignal erscheint im Ausgang, ohne durch sich in ihrer Größe ändernde Gleichanteile überlagert zu sein.

Wird dem Umsetzer ein n-Bit breites Digitalsignal zugeführt, in dessen Abhängigkeit das Wechselstromsignal bezüglich seiner Amplitude verändert werden soll, so sind für das Kettennetzwerk (n + m) Verbindungspunkte vorzusehen, wobei (n + m) ganze natürliche Zahlen größer Null sind. Der Wert m kann im Prinzip frei gewählt werden, wird jedoch aus Gründen des möglichst geringen Aufwands der Schaltung gleich 1 oder gleich 2 gewählt werden.

Bei diesem Kettennetzwerk mit (n + m) Verbindungspunkten liefert der letzte Vebindungspunkt, also der Verbindungspunkt (n + m) des Ausgangssignals des Umsetzers.

Es sind zwei Stromspiegelanordnungen vorgesehen, welche jeweils einen konstanten Strom liefern. Die beiden Ströme haben verschiedene Größe und werden entsprechend der Wertigkeit der Bits nicht jeweils auf die gleichen Verbindungspunkte geschaltet.

Weist das Kettennetzwerk (n + m) Verbindungspunkte auf, so ist der erste Strom einer ersten Stromspiegelanordnung auf die Verbindungspunkte (1 + m) bis (n + m) einzeln aufschaltbar. Dabei ist jedem Verbindungspunkt genau 1 Bit des Digitalsignals zugeordnet, und zwar in der Weise, daß dem Verbindungspunkt (1 + m) das niedrigswertige Bit und dem Verbindungspunkt (n + m) das höchstwertige Bit zugeordnet ist. Der erste Strom, den die erste Stromspiegelanordnung liefert, wird nun auf diejenigen Verbindungspunkte geschaltet, deren zugeordnetes Bit einen ersten Zustand hat, beispielsweise den Zustand high.

Die zweite der beiden Stromspiegelanordnungen liefert einen konstanten zweiten Strom, welcher größer ist als diejenige der ersten Stromspiegelanordnung. Dieser Strom ist auf die Verbindungspunkte 1 bis n einzeln aufschaltbar. Hier ist das niedrigstwertige Bit dem Verbindungspunkt 1 und das höchstwertige Bit dem Verbindungspunkt (n) zugeordnet. Auch dieser Strom wird in Abhängigkeit der Zustände der zugeordneten Bits dann auf den jeweils zugeordneten Verbindungspunkt geschaltet, wenn das zugeordnete Bit einen zweiten Zustand hat, beispielsweise den Zustand low.

Im Ergebnis werden also die beiden Ströme, die die Stromspiegelanordnungen liefern, um (m) Verbindungspunkte versetzt auf die (n + m) Verbindungspunkte geschaltet. Bei entsprechender Wahl der Größe des ersten und des zweiten Stromes und bei geeigneter Wahl der Zahl (m) kann damit erreicht werden, daß am Ausgang unabhängig vom Zustand der Bits des Digitalwortes bei konstanten ersten und konstanten zweiten Strom immer das gleiche Offsetsignal erscheint. Wird beispielsweise (m = 1) gewählt und der zweite Strom doppelt so groß gewählt wie der erste Strom, so ist diese Bedingung erfüllt. Dies rührt daher, daß beispielsweise dann, wenn das höchstwertige Bit des Digitalwortes High-Pegel hat, dem Verbindungspunkt Vm + 1 der erste Strom zugeführt wird. Hat das höchstwertige Bit des Digitalwortes dagegen den Wert low, so wird der zweite Strom dem Verbindungspunkt Vn zugeführt. Dieser Strom ist genau doppelt so groß wie der Strom $I_1$, wird jedoch durch das Kettennetzwerk halbiert, so daß am Ausgang nur der halbe Wert auftritt. Unabhängig von dem Zustand des höchstwertigen Bits tritt also am Ausgang immer das gleiche Offsetsignal auf. Entsprechendes gilt auch für die übrigen Bits des Digitalsignals.

Es kann nun also beispielsweise der Strom $I_1$ in seiner Größe verändert werden, was zur Folge hat, daß dieser vollständige Potentialausgleich nicht mehr stattfindet, so daß am Ausgang Stromwerte bzw. Spannungswerte auftreten, die in Abhängigkeit der Zustände der Bits des Digitalwortes veränderbar sind.

Dieser Digital-Analog-Umsetzer ist also als multiplizierender Umsetzer einsetzbar, wobei ein teilweise oder vollständiger Potentialausgleich möglich ist.

Für praktische Anwendungen wird der Digital-Analog-Umsetzer im allgemeinen so ausgelegt sein, daß die beiden von den Stromspiegelanordnungen gelieferten Gleichströme konstante Werte haben. Es wird dann, wie nach einer Ausgestaltung der Erfindung vorgesehen ist, der von der ersten Stromspiegelanordnung gelieferte Gleichstrom von einem Wechselstrom überlagert, der in dem Ausgangssignal des Umsetzers mit in Abhängigkeit des Digitalsignals veränderter Amplitude enthalten ist.

Soll diese Einstellung der Amplitude des Wechselstromsignals mit vollständigem Potentialausgleich erfolgen, d.h. soll das in seiner Amplitude eingestellte Signal am Ausgang des Umsetzers nicht von einem sich in Abhängigkeit der Zustände des Bits des Digitalsignals verändernden Gleichstromsignal überlagert sein, so ist gemäß einer weiteren Ausgestaltung vorgesehen, daß für diesen vollständigen Potentialausgleich des Ausgangssignals der Wert des Stromes $I_2$ der zweiten Stromspiegelanordnung das (2 x m)-fache des Wertes des Stromes $I_1$ der ersten Stromspiegelanordnung beträgt.

Damit gestattet der multiplizierende Digital-Analog-Umsetzer eine Einstellung der Amplitude des Wechselstromsignals ohne störende Nebeneffekte. Die Gesamtschaltung bleibt dabei gegenüber anderen Lösungen in ihrem Aufbau sehr einfach und hat darüber hinaus den Vorteil, relativ rauscharm zu sein.

Für gegebenenfalls gewünschten nur teilweisen Potentialausgleich besteht nach einer weiteren Ausgestaltung der Erfindung die Möglichkeit, den Wert des Stromes $I_2$ der zweiten Stromspiegelanordnung ungleich dem (2 x m)-fachen des Wertes $I_1$ der ersten Stromspiegelanordnung zu wählen.

Für die meisten Anwendungsfälle ist es hinreichend, wie nach einer weiteren Ausgestaltung vorgesehen ist, (m = 1) zu wählen. Es ist dann also ein Verbindungspunkt mehr in dem Kettennetzwerk vorgesehen als das Digitalwort Bits aufweist. In diesem Beispielsfalle ist für vollständigen Potentialausgleich der Strom $I_2$ doppelt so groß wie der Strom $I_1$ zu wählen. Die beiden Stromspiegelanordnungen sind so auszulegen, daß sie möglichst konstante und rauscharme Ströme liefern.

Dazu ist für die erste Stromspiegelanordnung vorgesehen, daß sie einen ersten Transistor, dessen Kollektor der Strom $I_1$ zugeführt wird, dessen Emitter, vorzugsweise über einen Widerstand, mit Bezugspotential verbunden ist und dessen Kollektor und Basis miteinander verbunden sind, und zweite Transistoren aufweist, von denen je einer jedem der Verbindungspunkte (1 + m) bis (n + m) zugeordnet ist und mit seinem Kollektor mit dem zugeordneten Verbindungspunkt und mit seinem Emitter, vorzugsweise über einen Widerstand, mit Bezugspotential verbunden ist, wobei die Basen der zweiten Transistoren mit der Basis des ersten Transistors verbunden sind.

Derjenige Strom, den die erste Stromspiegelanordnung liefert, nämlich der Strom $I_1$, wird dieser Anordnung von außen zugeführt und wird durch die verschiedenen Stromspiegel, die der erste Transistor mit dem zweiten Transistoren bildet, in konstanter Größe dem zugeordneten Verbindungspunkten zugeführt.

Nach einer weiteren Ausgestaltung ist für die zweite Stromspiegelanordnung vorgesehen, daß sie einen ersten Transistor, dessen Kollektor der Strom $I_2$ zugeführt wird, dessen Emitter, vorzugsweise über einen Widerstand mit Bezugspotential verbunden ist, und einen zweiten Transistor aufweist, dessen Basis der Strom $I_2$ zugeführt wird, dessen Kollektor eine Versorgungsspannung zugeführt wird und dessen Emitter mit der Basis des ersten Transistors verbunden ist, und daß die zweite Stromspiegelanordnung n dritte Transistoren aufweist, von denen je einer jedem der Verbindungspunkte 1 bis n zugeordnet ist und mit seinem Kollektor dem zugeordneten Verbindungspunkt und mit seinem Emitter, vorzugsweise über einen Widerstand, mit Bezugspotential verbunden ist, wobei die Basen der dritten Transistoren mit der Basis des ersten Transistors über Widerstände R'1, R'2 bzw. R'3 verbunden sind.

Die zweite Stromspiegelanordnung ist ähnlich aufgebaut wie die erste, jedoch mit dem Unterschied, daß zusätzlich ein zweiter Transistor vorgesehen ist, welcher kollektorseitig mit einer Versorgungsspannung verbunden ist. Damit wird erreicht, daß bei relativ großem Strombedarf der Schaltung die Größe der auf die Verbindungspunkte geschalteten Ströme nahezu konstant bleibt.

Für diese beiden Stromspiegelanordnungen mit jeweils intern einigen Stromspiegelschaltungen ist gemäß einer weiteren Ausgestaltung vorgesehen, daß die Basen der dritten Transistoren der zweiten Stromspiegelanordnung über je einen zugeordneten Schalter auf Bezugspotential schaltbar sind, welche in Abhängigkeit des Zustands des jeweils zugeordneten Bits des Digitalsignals geschaltet wird, und daß die Ströme $I_1$ bzw. $I_2$ der beiden Stromspiegelanordnungen so gewählt werden, daß bei geöffnetem Schalter der jeweils zugeordnete zweite Transistor der ersten Stromspiegelschaltung sperrt und der jeweils zugeordnete dritte Transistor der zweiten Stromspiegelanordnung leitend geschaltet ist und daß bei geschlossenem Schalter der jeweils zugeordnete zweite Transistor der ersten Stromspiegelanordnung leitend geschaltet ist und der zugeordnete dritte Transistor der zweiten Stromspiegelanordnung sperrt.

Durch diese Verschaltung der beiden Stromspiegelanordnungen und die geeignete Wahl der Ströme $I_1$ bzw. $I_2$ der beiden Stromspiegelanordnungen genügt ein einfacher Schalter, der zwischen die Basis der dritten Transistoren der zweiten Stromspiegelanordnung und Bezugspotential geschaltet ist. Für jedes Bit des Digitalsignals bzw. für jeden dritten Transistor der zweiten Stromspiegelanordnung ist dann ein Schalter vorgesehen, der entsprechend dem Zustand des zugeordneten Bits geschaltet wird. Durch die Umschaltung dieses Schalters, der im Normalfall als elektronischer Schalter ausgelegt sein wird, wird dann entsprechend dem Zustand des zugeordneten Bits entweder der zugeordnete zweite Transistor der ersten Stromspiegelanordnung oder der zugeordnete dritte Transistor der zweiten Stromspiegelanordnung leitend geschaltet. Dabei ist jedoch zu berücksichtigen, daß die Ströme, die diese beiden Transistoren auf die Verbindungspunkte schalten, auf verschiedene Verbindungspunkte geschaltet werden, wie dies oben erläutert wurde. So wird beispielsweise in Abhängigkeit des Zustandes des höchstwertigen Bits der Strom der ersten Stromspiegelanordnung auf den Verbindungspunkt Vn + m geschaltet, während der Strom der zweiten Stromspiegelanordnung in Abhängigkeit dieses Bits auf den Verbindungspunkt Vn geschaltet wird.

Eine weitere Ausgestaltung der Erfindung sieht eine Verwendung des Digital-Analog-Umsetzers für einen Audio- und/oder Video-Wiedergabegerät zur Beeinflussung der Amplitude eines dem ersten konstanten Strom überlagerten Analogsignals vor, insbesondere eines Lautstärke-, Kontrast- oder Farbsättigungssignals eines Farbfernsehgerätes. Da für den dem ersten Strom überlagerten Wechselstrom, der mittels des Umsetzers bezüglich seiner Amplitude einstellbar ist, ein vollständiger oder auch teilweiser Potentialausgleich möglich ist, ist ein Einsatz eines derartigen multiplizierenden Umsetzers für praktisch alle Audio- und/oder Videogeräte möglich. Insbesondere in einem Fernsehgerät sind eine Fülle von analogen Einstellwerten bezüglich ihrer Amplitude zu verändern, wobei teilweise vollständiger Potentialausgleich erwünscht ist. Dies gilt beispielsweise für Lautstärke- oder Konstrasteinstellung. Für andere Werte ist nur ein teilweiser Potentialausgleich gewünscht. Der erfindungsgemäße Umsetzer eignet sich also mit seiner einerseits multiplizierenden Eigenschaft und dem andererseits möglichen teilweisen oder vollständigen Potentialausgleich geradezu ideal für derartige Einsatzzwecke. Dabei ist sein Aufbau relativ einfach und das in seiner Amplitude einzustellende Signal wird mit relativ wenig Rauschen überlagert.

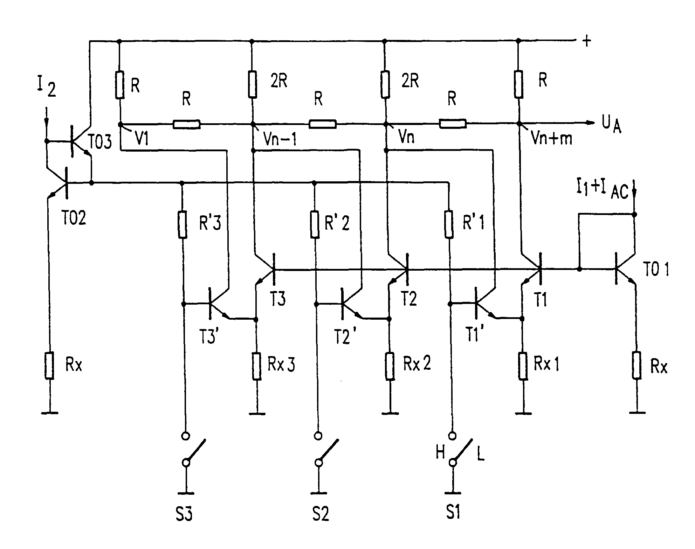

Ein Ausführungsbeispiel der Erfindung wird anhand der Zeichnung näher erläutert.

Die Figur zeigt einen multiplizierenden Digital-Analog-Umsetzer, der für ein 3-Bit breites Digitalsignal ausgelegt ist. Diese Auslegung wurde für eine möglichst übersichtliche Darstellung in der Figur gewählt, selbstverständlich kann der Umsetzer beispielsweise auch für sechs, zehn oder mehr Bits des Digitalsignals ausgelegt sein.

Für den in der Figur dargestellten Umsetzer wurde der Wert (m = 1) gewählt, entsprechend weist ein in dem dargestellten Umsetzer vorgesehenes Kettennetzwerk (n + m = 3 + 1 = 4) Verbindungspunkte auf. Diese Verbindungspunkte sind in der Figur mit V1, Vn-1, Vn und Vn + m bezeichnet. Die Verbindungspunkte werden jeweils durch Längswiderstände R verbunden. Es sind im übrigen Querwiderstände 2R vorgesehen, die auf eine Versorgungsspannung geführt sind. Die Querwiderstände an den beiden Enden des Kettennetzwerkes weisen einen Widerstandswert R auf. Der Verbindungspunkt Vn + m bildet den Ausgang des Umsetzers.

Durch die Wahl der Widerstandswerte der Widerstände des Kettennetzwerkes wird erreicht, daß ein beispielsweise gleichgroßer Strom, der den Verbindungspunkten zugeführt wird, für jeden Verbindungspunkt, der weiter von dem den Ausgang der Schaltung darstellenden Verbindungspunkt entfernt liegt, jeweils an diesem Ausgang nur ein halb so großes Signal erzeugt.

Der Umsetzer weist ferner zwei Stromspiegelanordnungen auf, deren Ströme in Abhängigkeit der Zustände eines Digitalwortes auf die verschiedenen Verbindungspunkte geschaltet werden.

Ist eine erste Stromspiegelanordnung vorgesehen, welche einen ersten Transistor T01 aufweist, welchem kollektorseitig ein Strom $I_1$ zugeführt wird. Bei diesem Strom $I_1$ handelt es sich um einen konstanten Gleichstrom. Diesem konstanten Gleichstrom ist ein Wechselstrom $I_{AC}$ überlagert.

Der erste Transistor T01 der ersten Stromspiegelanordnung ist emitterseitig über einen Widerstand Rx mit Bezugspotential verbunden. Die dem Kollektor zugeführten Ströme werden auch auf die Basis des Transistors T01 geführt, welche darüber hinaus mit den Basen weiterer Transistoren verbunden ist, die die zweiten Transistoren der Stromspiegelanordnung darstellen, und die in der Figur mit T1, T2 und T3 bezeichnet sind. Die Emitter der Transistoren T1, T2 bzw. T3 sind über EmitterwiderRx1, Rx2 bzw. Rx3 auf Bezugspotential geführt.

Der Kollektor des Transistors T1 ist auf den Verbindungspunkt Vn + m, der Kollektor des Transistors T2 auf den Verbindungspunkt Vn und der Kollektor des Transistors T3 auf den Verbindungspunkt Vn - 1 geführt.

Wie nachfolgend noch weiter erläutert werden wird, ist dem Transistor 1 das höchstwertige Bit des Digitalsignals und dem Transistor T3 das niedrigswertige Bit des Digitalsignals zugeordnet.

Die zweite Stromspiegelanordnung weist einen ersten Transistor T02 und einen zweiten Transistor T03 auf. Der Anordnung wird von außen ein konstanter Gleichstrom $I_2$ zugeführt, der auf den Kollektor des ersten Transistors T02 und die Basis des zweiten Transistors T03 geführt ist. Emitterseitig ist der erste Transistor T02 über einen Widerstand Rx auf Bezugspotential geführt. Der Emitter des zweiten Transistors T03 ist mit der Basis des ersten Transistors T02 verbunden. Der Kollektor des zweiten Transistors T03 ist auf eine Versorgungsspannung geführt.

Es sind ferner in der zweiten Stromspiegelanordnung dritte Transistoren T1', T2' und T3' vorgesehen, welche basisseitig jeweils über einen Widerstand R'1, R'2 bzw. R'3 mit der Basis des ersten Transistors T02 verbunden sind. Diese Transistoren bilden zusammen mit dem ersten Transistor Stromspiegel. Die Basen der Transistoren T1', T2' bzw. T3' sind jeweils über einen Schalter S1, S2 bzw. S3 auf Bezugspotential schaltbar. Diese Schalter sind den Bits des Digitalsignals zugeordnet und werden in dem einen

Zustand des ihm jeweils zugeordneten Bits geöffnet und in dem anderen Zustand geschlossen.

Die Emitter der Transistoren T1', T2' bzw. T3' sind mit den Emittern der jeweils zugeordneten Transistoren T1, T2 bzw. T3 verbunden.

Der Kollektor des Transistors T1' ist mit dem Verbindungspunkt Vn, der Kollektor des Transistors T2' mit den Verbindungspunkten Vn - 1 und der Kollektor des Transistors T3' mit dem Verbindungspunkt V1 verbunden.

Den Transistoren T1 der ersten Stromspiegelanordnung und T1' der zweiten Stromspiegelanordnung ist der Schalter S1 zugeordnet, welcher in Abhängigkeit des Zustandes des höchstwertigen Bits eines in der Figur nicht dargestellten Digitalsignals geschaltet wird. Das nächstniedrigstwertige Bit schaltet den Schalter S2, den die Transistoren T2 und T2' zugeordnet sind. Das niedrigstwertige Bit des Digitalsignals bestimmt die Stellung des Schalters S3, dem die Transistoren T3 bzw. T3' zugeführt sind.

Im folgenden wird davon ausgegangen, daß die Schaltung einen vollständigen Potentialausgleich schaffen soll. Dafür ist in dem in der Figur dargestellten Beispielsfalle, in dem der Wert der Zahl (m = 1) gewählt wurde, der Strom $I_2$ doppelt so groß zu wählen wie der Strom $I_1$. Wird zunächst davon ausgegangen, daß der Wechselstrom $I_{AC}$ gleich Null ist, so erscheint am Ausgang des Umsetzers, der von dem Verbindungspunkt Vn + n gebildet wird, unabhängig von dem Zustand der Bits des Digitalsignals immer das gleiche Ausgangssignal, d.h. also ein Ausgangssignal mit konstantem Potential.

Dieser Zusammenhang kann anhand beispielsweise des höchstwertigen Bits erläutert werden:

Hat das höchstwertige Bit des Digitalsignals beispielsweise den Zustand high und ist bei diesem Zustand der zugeordnete Schalter S1 geschlossen, so sperrt der Transistor T1' der zweiten Stromspiegelanordnung, d.h. er führt keinen Strom in seinem Kollektor. Gleichzeitig ist jedoch der Transistor T1 der ersten Stromspiegelanordnung leitend geschaltet, so daß in seinem Kollektor der Strom $I_1$ fließt, der auf dem Verbindungspunkt Vn + m geführt wird. Entsprechend diesem Strom erscheint also am Ausgang ein Potential. Hat das höchstwertige Bit dagegen den Zustand low und ist also der Schalter S1 geöffnet, so ist der Transistor T1' der zweiten Stromspiegelanordnung leitend geschaltet und sein Kollektor führt den Strom $I_2$, der jedoch den Verbindungspunkt Vn zugeführt wird. Der erste Transistor T1 ist in diesem Falle sperrend geschaltet, und führt dem Verbindungspunkt Vm kein Strom zu. Der von dem Transistor T1' der zweiten Stromspiegelanordnung auf dem Verbindungspunkt Vn geführte Strom $I_2$ ist zwar doppelt so groß wie der Strom $I_1$, wird jedoch durch das Kettennetzwerk entsprechend heruntergeteilt, so daß am Ausgang bzw. an dem Verbindungspunt Vn + m das gleiche Ausgangssignal erscheint, wie in dem vorigen Fall, indem der Schalter S1 geschlossen und das zugeordnete Bit High-Pegel hatte. Es erscheint also am Ausgang des Umsetzers immer das gleiche Potential, welches unabhängig von dem Zustand des höchstwertigen Bits ist. Entsprechendes gilt in gleicher Weise für die übrige Schaltung, d.h. also für die übrigen Bits des Digitalsignals. Mit anderen Worten kann das Digitalsignal beliebige Werte annehmen, am Ausgang des Umsetzers wird immer das gleiche Potential erscheinen.

Diese Eigenschaft kann nun dazu eingesetzt werden, ein dem Umsetzer von außen zugeführtes Wechselstromsignal $I_{AC}$ bezüglich seiner Amplitude zu verändern. Dieses Wechselstromsignal $I_{AC}$ wird dem ersten Strom $I_1$ überlagert und wird also in Abhängigkeit der Zustände der Bits des Digitalsignals mittels der Transistoren T1, T2 und T3 auf die jeweiligen Verbindungspunkte geschaltet bzw. nicht geschaltet. In Abhängigkeit des Digitalwortes und damit der leitend bzw. nicht leitend geschalteten Transistoren T1 bis T3 wird das Wechselstromsignal auf verschiedene Verbindungspunkte des Kettennetzwerkes geschaltet und damit verschieden stark heruntergeteilt. Somit erscheint das Wechselstromsignal am Ausgang des Umsetzers mit in Abhängigkeit der Zustände der Bits des Digitalsignals veränderter Amplitude.

Diese Amplitudeneinstellung des Wechselstromsignals am Ausgang des Umsetzers geschieht dabei äußerst rauscharm und insbesondere ohne störende Nebeneffekte, d.h. also ohne Gleichspannungsprünge am Ausgang der Schaltung, welche bei konventionellen multiplizierenden digitalen Dialogumsetzern in Abhängigkeit der Zustände des Digitalsignals auftreten, da bei diesen konventionellen Umsetzern zusätzlich der Gleichstrom $I_1$ durch den Umsetzer umgesetzt wird und quasi als eine Art Gleichanteil am Ausgang erscheint.

Selbstverständlich ist es bei der erfindungsgemäßen Schaltung auch möglich, einen nicht vollständigen Potentialausgleich vorzunehmen, in dem in der Figur dargestellten Beispielsfalle also den Strom $I_2$ nicht gleich doppelt so groß zu wählen wie den Strom $I_1$. Dann ist am Ausgang des Umsetzers dem in seiner Amplitude eingestellten Wechselstromsignal zusätzlich ein

Gleichstromsignal überlagert, welches in Abhängigkeit der Zustände der Bits verändert wird.

Allgemein gilt dabei, daß der Strom $I_2$ um so vieles größer sein muß als der Strom $I_1$, daß in Abhängigkeit der Schalter S1 bis S3 ein Umschalten zwischen den zugeordneten Transistoren stattfinden kann. Für die Darstellung gemäß der Figur gilt dabei, daß gelten muß:

$$I_2 \times Rx > I_1 \times Rx + 100 \text{ mV}.$$

Ist diese Bedingung erfüllt, so kann beispielsweise der Transistor T1' bei geöffnetem Schalter S1 sicher durchschalten, wobei gleichzeitig der Transistor T1 gesperrt ist.

**Patentansprüche**

1. Multiplizierender Digital-Analog-Umsetzer mit einem R-2R-Kettennetzwerk, dessen Längswiderstände und dessen an den beiden Kettennetzwerkenden liegenden Querwiderstände jeweils einen Widerstandswert R und dessen übrige Querwiderstände einen doppelten Widerstandswert 2R aufweisen, wobei die den Längswiderständen abgewandten Enden der Querwiderstände mit einer Versorgungsspannung beaufschlagt sind und die den Längswiderständen zugewandten Enden der Querwiderstände Verbindungspunkte bilden, <u>dadurch gekennzeichnet,</u> daß

- das Kettennetzwerk für ein n-Bit breites, dem Umsetzer zugeführtes Digitalsignal (n + m) Verbindungspunkte aufweist, wobei n, m ganze natürliche Zahlen größer Null sind,
- der Verbindungspunkt (n + m) das Ausgangssignal des Umsetzers liefert,
- eine erste Stromspiegelanordnung vorgesehen ist, die einen konstanten ersten Strom liefert, der den Verbindungspunkten (1 + m) bis (n + m) einzeln aufschaltbar ist, wobei das niedrigswertige Bit des Digitalsignals dem Verbindungspunkt (1 + m) und das höchstwertige Bit dem Verbindungspunkt (n + m) zugeordnet ist und wobei der erste Strom nur auf diejenigen Verbindungspunkte geschaltet wird, deren zugeordnetes Bit einen ersten Zustand hat, und
- eine zweite Stromspiegelanordnung vorgesehen ist, die einen konstanten zweiten Strom liefert, welcher größer ist als derjenige der ersten Stromspiegelanordnung und der den Verbindungspunkten 1 bis n einzeln aufschaltbar ist, wobei das niedrigstwertige Bit dem Verbindungspunkt 1 und das höchstwertige Bit dem Verbindungspunkt n zugeordnet ist und wobei der zweite Strom nur auf diejenigen Verbindungspunkte geschaltet wird, deren zugeordnetes Bit einen zweiten Zustand hat.

2. Digital-Analog-Umsetzer nach Anspruch 1, <u>dadurch gekennzeichnet,</u> daß der von der ersten Stromspiegelanordnung gelieferte Strom von einem Wechselstrom überlagert ist, der in dem Ausgangssignal des Umsetzers mit in Abhängigkeit des Digitalsignals veränderter Amplitude enthalten ist.

3. Digital-Analog-Umsetzer nach Anspruch 2, <u>dadurch gekennzeichnet,</u> daß für vollständigen Potentialausgleich des Ausgangssignals der Wert des Stromes $I_2$ der zweiten Stromspiegelanordnung das (2 x m)-fache des Wertes des Stromes $I_1$ der ersten Stromspiegelanordnung beträgt.

4. Digital-Analog-Umsetzer nach Anspruch 2, <u>dadurch gekennzeichnet,</u> daß für nur teilweisen Potentialausgleich der Wert des Stromes $I_2$ der zweiten Stromspiegelanordnung ungleich dem (2 x m)-

fachen des Wertes $I_1$ der ersten Stromspiegelanordnung ist.

5. Digital-Analog-Umsetzer nach einem der Ansprüche 1 bis 4,
dadurch gekennzeichnet, daß m = 1 gewählt wird.

6. Digital-Analog-Umsetzer nach einem der Ansprüche 1 bis 5,
dadurch gekennzeichnet, daß die erste Stromspiegelanordnung einen ersten Transistor (T01), dessen Kollektor der Strom $I_1$ zugeführt wird, dessen Emitter, vorzugsweise über einen Widerstand (Rx), mit Bezugspotential verbunden ist und dessen Kollektor und Basis miteinander verbunden sind, und n zweite Transistoren (T1, T2, T3) aufweist, von denen je einer je einem Verbindungspunkte (1 + m) bis (m + m) zugeordnet ist und mit seinem Kollektor mit dem zugeordneten Verbindungspunkt (Vn + m, Vn, Vn-1) und mit seinem Emitter, vorzugsweise über einen Widerstand (Rx1, Rx2, Rx3), mit Bezugspotential verbunden ist, wobei die Basen der zweiten Transistoren (T1, T2, T3) mit der Basis des ersten Transistors (T01) verbunden sind.

7. Nach einem der Ansprüche 1 bis 6,
dadurch gekennzeichnet, daß die zweite Stromspiegelanordnung einen ersten Transistor (T02), dessen Kollektor der Strom $I_2$ zugeführt wird, dessen Emitter, vorzugsweise über einen Widerstand (Rx) mit Bezugspotential verbunden ist, und einen zweiten Transistor (T02) aufweist, dessen Basis der Strom $I_2$ zugeführt wird, dessen Kollektor eine Versorgungsspannung zugeführt wird und dessen Emitter mit der Basis des ersten Transistors verbunden ist, und daß die zweite Stromspiegelanordnung n dritte Transistoren (T1', T2', T3') aufweist, von denen je einer je einem der Verbindungspunkte 1 bis n zugeordnet ist und mit seinem Kollektor dem zugeordneten Verbindungspunkt (Vn, Vn-1, V2) und mit seinem Emitter, vorzugsweise über einen Widerstand (Rx1, Rx2, Rx3), mit Bezugspotential verbunden ist, wobei die Basen der dritten Transistoren (T1', T2', T3') über je einen Widerstand (R'1, R'2, R'3) mit der Basis des ersten Transistors (T02) verbunden sind.

8. Digital-Analog-Umsetzer nach den Ansprüchen 6 und 7,
dadurch gekennzeichnet, daß die Basen der dritten Transistoren (T1', T2', T3') der zweiten Stromspiegelanordnung über je einen zugeordneten Schalter (S1, S2, S3) auf Bezugspotential schaltbar sind, welche in Abhängigkeit des Zustands des jeweils zugeordneten Bits des Digitalsignals geschaltet wird, und daß die Ströme $I_1$ bzw. $I_2$ der beiden Stromspiegelanordnungen so gewählt werden, daß bei geöffnetem Schalter (S1, S2, S3) der jeweils zugeordnete zweite Transistor (T1, T2, T3) der ersten Stromspiegelschaltung sperrt und der jeweils zugeordnete dritte Transistor (T1', T2', T3') der zweiten Stromspiegelanordnung leitend geschaltet ist und daß bei geschlossenem Schalter (S1, S2, S3) der jeweils zugeordnete zweite Transistor (T1, T2, T3) der ersten Stromspiegelanordnung leitend geschaltet ist und der zugeordnete dritte Transistor (T1', T2', T3') der zweiten Stromspiegelanordnung sperrt.

9. Verwendung des Digital-Analog-Umsetzers nach einem der Ansprüche 1 bis 8 für ein Audio- und/oder Video-Wiedergabegerät zur Beeinflussung der Amplitude eines dem ersten konstanten Strom überlagerten Analogsignals, insbesondere eines Lautstärke-, Kontrast- oder Farbsättigungssignals eines Farbfernsehgerätes.

**Claims**

1. Multiplying digital-to-analog converter, which comprises a R-2R chain network, whose series resistors and whose shunt resistors positioned at either one of the two ends of the chain network each have a resistance R and whose remaining shunt resistors have a double resistance 2R, in which a supply voltage is impressed on the shunt resistor ends remote from the series resistors and the shunt resistor ends near to the series resistors form connection points, characterized in that

   - the chain network for an n-bit-wide digital signal applied to the converter comprises (n+m) connection points, where n,m are natural integers greater than zero,
   - the connection point (n+m) produces the analog signal of the converter,
   - a first current mirror arrangement is provided which produces a constant first current that can be switched to the individual connection points (1+m) to (n+m), while the least significant bit of the digital signal is allocated to the connection point (1+m) and the most significant bit is allocated to the connection point (n+m), and the first current is switched only to those connection points whose allocated bit has a first state, and
   - a second current mirror arrangement is provided which produces a constant second current that is larger than that of the first current mirror arrangement and can be switched to the individual connection points 1 to n, while the least significant bit is allocated to the connection point 1 and the most significant bit is allocated to the connection point n, and the second current is switched only to those connection points whose allocated bit has a second state.

2. Digital-to-analog converter as claimed in claim 1, characterized in that the current produced by the first current mirror arrangement is superposed by an AC current which is contained in the output signal of the converter and has an amplitude that has changed as a function of the digital signal.

3. Digital-to-analog converter as claimed in claim 1 or 2, characterized in that for a complete potential equalization of the output signal, the value of the current $I_2$ of the second current mirror arrangement is (2xm) times the values of the current $I_1$ of the first current mirror arrangement.

4. Digital-to-analog converter as claimed in Claim 2, characterized in that for a partial potential equalization, the value of the current $I_2$ of the second current mirror arrangement is not equal to (2xm) times the value $I_1$ of the first current mirror arrangement.

5. Digital-to-analog converter as claimed in one of the claims 1 to 4, characterized in that m = 1.

6. Digital-to-analog converter as claimed in one of the claims 1 to 5, characterized in that the first current mirror arrangement comprises a first transistor (T01) whose collector receives a current $I_1$, whose emitter is connected to a reference potential preferably through a resistor (Rx) and whose collector and base are connected to each other, and comprises n second transistors (T1, T2, T3), each one of which is allocated to one of the connection points (1+m) to (n+m), the collectors of which being connected to the allocated connection point (Vn+m, Vn, Vn-1) and the emitters of which being connected to a reference potential preferably through a resistor (Rx1, Rx2, Rx3), the bases of said second transistors (T1, T2, T3) being connected to the base of the first transistor (T01).

7. Digital-to-analog converter as claimed in one of the claims 1 to 6, characterized in that the second current mirror arrangement comprises a first transistor (T02), whose collector receives the current $I_2$, whose emitter is connected to a reference potential preferably through a resistor (Rx), and comprises a second transistor (T03), whose base is supplied with the current $I_2$, whose collector is supplied with a supply voltage, and whose emitter is connected to the base of the first transistor, and in that the second current mirror arrangement comprises n third transistors (T1', T2', T3'), each one of which is allocated to one of the connection points 1 to n, and the collectors of which being connected to the allocated connection points (Vn, Vn-1, V2), the emitters of which being connected to a reference potential preferably through a resistor (Rx1, Rx2, Rx3), and the bases of the third transistors (T1', T2', T3') being connected to the base of the first transistor (T02) through resistors (R'1, R'2, R'3).

8. Digital-to-analog converter as claimed in the claims 6 and 7, characterized in that the bases of the third transistors (T1', T2', T3') of the second current mirror arrangement can each be switched to a reference potential via an allocated switch (S1, S2, S3), which second arrangement is switched as a function of the state of the allocated bit of the digital signal, and in that the currents $I_1$ and $I_2$ of the two current mirror arrangements are chosen so that when the switch (S1, S2, S3) is open, the allocated second transistor (T1, T2, T3) of the first current mirror arrangement is cut off and the allocated third transistor (T1', T2', T3') of the second current mirror arrangement is rendered conductive, and in that when the switch (S1, S2, S3) is closed, the allocated second transistor (T1, T2, T3) of the first current mirror arrangement is rendered conductive and the allocated third transistor (T1', T2', T3') of the second current mirror arrangement is cut off.

9. Use of the digital-to-analog converter as claimed in one of the claims 1 to 8 for an audio and/or video playback device to influence the amplitude of an analog signal superposed on the first constant current, more specifically, a volume signal, contrast signal or a colour saturation signal of a colour television set.

**Revendications**

1. Convertisseur numérique-analogique multiplicateur avec un réseau en chaîne R-2R dont les résistances longitudinales et dont les résistances transversales disposées aux deux extrémités du réseau en chaîne présentent respectivement une valeur de résistance R et les autres résistances transversales une double valeur de résistance 2R, les extrémités des résistances transversales opposées aux résistances longitudinales étant alimentées en une tension d'alimentation et les extrémités des résistances transversales tournées vers les résistances longitudinales formant des points de jonction,
  caractérisé en ce que

  - le réseau en chaîne présente pour un signal numérique d'une largeur de n bits amené au convertisseur (n+m) points de jonction, n et m étant des nombres entiers naturels supérieurs à zéro,
  - le point de jonction (n+m) délivre le signal de sortie du convertisseur,
  - un premier dispositif de niveau de courant est prévu et délivre un premier courant constant qui peut être appliqué individuellement sur les points de jonction (1+m) à (n+m), le bit de valeur minimale du signal numérique étant affecté au point de jonction (1+m) et le bit de valeur maximale étant affecté au point de jonction (n+m) et le premier courant n'étant appliqué que sur les points de jonction dont le bit affecté présente un premier état, et

- un deuxième dispositif de niveau de courant est prévu et délivre un deuxième courant constant qui est supérieur à celui du premier dispositif de niveau de courant et peut être commuté individuellement sur les points de jonction 1 à n, le bit de valeur minimale étant affecté au point de jonction 1 et le bit de valeur maximale au point de jonction n et le deuxième courant n'étant appliqué que sur les points de jonction dont le bit affecté a un deuxième état.

2. Convertisseur numérique-analogique selon la revendicationl,

caractérisé en ce que le courant délivré par le premier dispositif de niveau de courant est superposé par un courant alternatif qui est contenu dans le signal de sortie du convertisseur avec une amplitude variable en fonction du signal numérique.

3. Convertisseur numérique-analogique selon la revendication 2,

caractérisé en ce que, pour la compensation complète du potentiel du signal de sortie, la valeur du courant $I_2$ du deuxième dispositif de niveau de courant s'élève à $(2 \times m)$ fois la valeur du courant $I_1$ du premier dispositif du niveau de courant.

4. Convertisseur numérique-analogique selon la revendication2,

caractérisé en ce que, pour une compensation seulement partielle du potentiel, la valeur du courant $I_2$ du deuxième dispositif de niveau de courant n'est pas égale à $(2 \times m)$ fois la valeur $I_1$ du premier dispositif de niveau de courant.

5. Convertisseur numérique-analogique selon l'une des revendications 1 à 4, caractérisé en ce que m=1.

6. Convertisseur numérique-analogique selon l'une des revendications 1 à 5, caractérisé en ce que le premier dispositif de niveau de courant présente un premier transistor (T01) au collecteur duquel est amené le courant $I_1$ et dont l'émetteur est relié, de préférence par l'intermédiaire d'une résistance (Rx), à un potentiel de référence et dont le collecteur et la base sont reliés entre eux et présentent n deuxièmes transistors (T1, T2, T3) dont respectivement un est affecté à l'un des points de jonction (1+m) à (n+m) et avec son collecteur au point de jonction affecté (Vn+m, Vn, Vn-1) et avec son émetteur, de préférence par l'intermédiaire d'une résistance (Rx1, Rx2, Rx3) à un potentiel de référence, les bases des deuxièmes transistors (T1, T2, T3) étant reliées à la base du premier transistor (T01).

7. Convertisseur numérique-analogique selon l'une des revendications 1 à 6, caractérisé en ce que le deuxième dispositif de niveau de courant présente un premier transistor (T02) au collecteur duquel est amené le courant $I_2$ et dont l'émetteur est relié, de préférence par l'intermédiaire d'une résistance (Rx) à un potentiel de référence et un deuxième transistor (T02) à la base duquel est amené le courant $I_2$ et au collecteur duquel est amenée une tension d'alimentation et dont l'émetteur est relié à la base du premier transistor et en ce que le deuxième dispositif de niveau de courant présente n troisièmes transistors (T1', T2', T3') dont respectivement un est affecté à l'un des points de jonction 1 à n et est relié par son collecteur au point de jonction affecté (Vn, Vn-1, V2) et avec son émetteur, de préférence par l'intermédiaire d'une résistance (Rx1, Rx2, Rx3) à un potentiel de référence, les bases des troisièmes transistors (T1', T2', T3') étant reliées respectivement par l'intermédiaire d'une résistance (R'1, R'2, R'3) à la base du premier transistor (T02).

8. Convertisseur numérique-analogique selon les revendications 6 et 7,

caractérisé en ce que les bases des troisièmes transistors (T1', T2', T3') du deuxième dispositif de niveau de courant peuvent respectivement être commutées par l'intermédiaire d'un commutateur affecté (S1, S2, S3) à un potentiel de référence qui est commuté en fonction de l'état du bit respectivement affecté du signal numérique et en ce que les courants $I_1$ ou $I_2$ des deux dispositifs de niveau de courant sont choisis de telle sorte que lorsque le commutateur est ouvert (S1, S2, S3), le deuxième transistor respectivement affecté (T1, T2, T3) du premier dispositif de niveau de courant est fermé et le troisième transistor respectivement affecté (T1', T2', T3') du deuxième dispositif de niveau de courant est monté de manière conductrice et qu'en cas de commutateur fermé (S1, S2, S3), le deuxième transistor (T1, T2, T3) respectivement affecté du premier dispositif de niveau de courant est monté de manière conductrice et le troisième transistor (T1', T2', T3') respectivement affecté du deuxième dispositif de niveau de courant est bloqué.

9. Mise en oeuvre du convertisseur numérique-analogique selon l'une des revendications 1 à 8 pour un dispositif de reproduction audio et/ou vidéo en vue d'influencer l'amplitude d'un signal analogique superposé au premier courant constant, en particulier un signal de volume, de contraste ou de saturation des couleurs d'un téléviseur couleur.